# EUROPEAN PATENT APPLICATION

(11) **EP 3 153 359 A1**
(43) Date of publication of application: **12.04.2017**
(21) Application number: 16190744.9
(22) Date of filing: 27.09.2016
(51) Int. Cl.: B60R 25/01, B60R 25/04, H05K 1/02, H05K 1/14, G01R 31/28

(54) **CIRCUIT BOARD STRUCTURE**

(30) Priority: 07.10.2015 JP 2015199497
(71) Applicant: KABUSHIKI KAISHA TOKAI RIKA DENKI SEISAKUSHO, Niwa-gun, Aichi 480-0195 (JP)
(72) Inventor: SENZAKI, Daisuke, Niwa-gun,, Aichi 480-0195 (JP); KAWAMURA, Masayuki, Niwa-gun,, Aichi 480-0195 (JP); KOJIMA, Hiroaki, Niwa-gun,, Aichi 480-0195 (JP)
(74) Representative: TBK

(57) **Abstract**

A circuit board structure includes a test terminal. The circuit board structure includes and interface circuit board and a functional circuit board (1 or 2). The interface circuit board includes common test terminals (12 and 13) shared by different functional circuit boards (1 and 2). The functional circuit board (1 or 2) realizes a product function. The functional circuit board (1 or 2) is selected from a plurality of functional circuit boards (1 and 2) respectively realizing different product functions. Circuit components (5 and 21-23) required for each product function are mounted on the corresponding functional circuit board (1 or 2).

## Description

The present invention relates to a circuit board structure including test terminals.

Japanese Laid-Open Patent Publication No. 2008-156849 describes a device provided with an electronic key function for automatically opening and closing a door lock without a mechanical key and a remote engine starting function for starting or stopping a vehicle engine from a distance. A portable device provided with the electronic key function is referred to as a portable electronic key device. A portable device provided with the remote engine starting function is referred to as a portable remote engine starting device. The portable electronic key device includes a first circuit board accommodated in a housing. Circuit components laid out on the first circuit board realize the electronic key function. A portable remote engine starting device includes a second circuit board accommodated in a housing. Circuit components laid out on the second circuit board realize the remote engine starting function.

The circuit components include an integrated circuit (IC), to which data needs to be written, and an IC or switch, which needs to undergo an operational inspection. Accordingly, the circuit board includes test terminals such as a write pad and a test terminal. When the locations of the test terminals differ between circuit boards, a test jig needs to be prepared for each circuit board.

Accordingly, it is an object of the present invention to provide a common test jig that is shared by different circuit boards.

One aspect of the invention is a circuit board structure including a test terminal. The circuit board structure includes an interface circuit board and a functional circuit board. The interface circuit board includes common test terminals shared by different functional circuit boards. The functional circuit board realizes a product function. Further, the functional circuit board is selected from a plurality of functional circuit boards respectively realizing different product functions, and circuit components required for each product function are mounted on the corresponding functional circuit board.

The invention, together with objects and advantages thereof, may best be understood by reference to the following description of the presently preferred embodiments together with the accompanying drawings in which:
Fig. 1 is a schematic diagram illustrating two types of functional circuit boards;
Fig. 2 is a schematic perspective view of a circuit board structure including a functional circuit board and an interface circuit board; and
Fig. 3 is a schematic diagram illustrating the interface circuit board.

One embodiment of a circuit board structure will now be described.

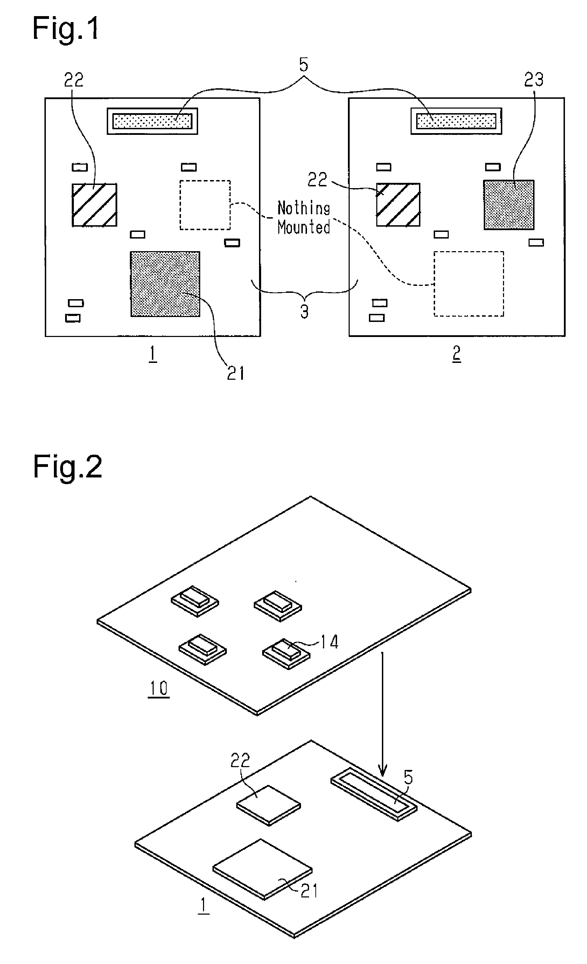

Referring to Fig. 1, a functional circuit board 1 that realizes the electronic key function (one example of product function) is prepared as product A. Further, a functional circuit board 2 that realizes the remote engine starting function (one example of product function) is prepared as product B. Each of the functional circuit board 1 and the functional circuit board 2 are formed from a common circuit board 3. A common pattern is formed on the common circuit board 3. The common pattern includes a mounting region for each circuit component used to realize the electronic key function and each circuit component used to realize the remote engine starting function. Thus, the functional circuit board 1 and the functional circuit board 2 prior to the mounting of the circuit components is the same type of circuit board (common circuit board 3).

The common circuit board 3 includes mounting regions for a connector 5 and ICs 21 to 23.

The IC21, which is the main CPU of product A, the IC22, the connector 5, and the like are mounted on the common circuit board 3 for the functional circuit board 1. The IC 21 and the IC 22 each correspond to a circuit component required for the electronic key function. The IC 23, which is the main CPU of product B, the IC 22, the connector 5, and the like are mounted on the common circuit board 3 for the functional circuit board 2. The IC 23 and the IC 22 each correspond to a circuit component required for the remote engine starting function. In the common circuit board 3 for the functional circuit board 1 (product A), the mounting region for the IC 23 (main CPU of product B) is free from circuit components. In the common circuit board 3 for the functional circuit board 1 (product B), the mounting region for the IC 21 (main CPU of product A) is free from circuit components.

As shown in Fig. 2, the functional circuit board 1 or the functional circuit board 2, which is selected in accordance with the product function, is connected to a common interface circuit board 10, which is shared by the functional circuit boards 1 and 2. For example, the functional circuit board 1 is selected to realize the electronic key function as the product function. The functional circuit board 1 is combined with the interface circuit board 10 to form a single circuit board structure.

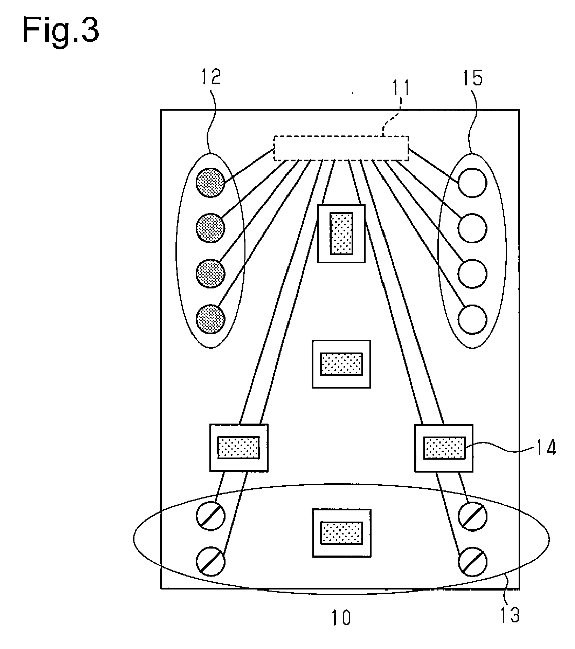

As shown in Fig. 3, the interface circuit board 10 includes a connector 11, write pads 12 and inspection pads 13. The connector 11 is connected to the connector 5 of the functional circuit board 1 or the functional circuit board 2. The write pads 12 are commonly used by the functional circuit board 1 and the functional circuit board 2 to write data to the IC 21 and the IC 23. The inspection pads 13 are used to inspect the IC 22. The write pads 12 and the inspection pads 13 each correspond to a test terminal shared by the functional circuit board 1 and the functional circuit board 2. Further, switch components 14 are mounted on the interface circuit board 10. The interface circuit board 10 also includes inspection pads 15 to conduct an operational inspection on each switch component 14.

The common circuit board 3 for the functional circuit board 1 or 2 includes the connector 5 that is electrically connected to the mounting regions. The interface circuit board 10 includes the connector 11 that is electrically connected to the test terminals. The connector 5 of the functional circuit board 1 or 2 is connected to the connector 11 of the interface circuit board 10. The connector 5 of the functional circuit board 1 or 2 includes common terminals connected to the circuit components. That is, the common terminals are connected to the combined set of circuit components in the corresponding functional circuit board 1 or 2. The connector 11 of the interface circuit board 10 includes terminals connected to the terminals of the connector 5. The terminals of the connector 11 are also electrically connected to the test terminals. The interface circuit board 10 is placed on the functional circuit board 1 or 2. The functional circuit board 1 and 2 each include an upper surface that is opposed to the interface circuit board 10. The connector 5 is mounted on the upper surface. The interface circuit board 10 includes a lower surface on which the connector 11 is mounted and an opposite upper surface. The test terminals 12 and 13 are mounted on the upper surface of the interface circuit board 10.

The operation of the circuit board structure will now be described.

Referring to Fig. 2, when the functional circuit board 1 (product A) and the interface circuit board 10 are combined to form a first circuit board structure, data needs to be written to the IC 21, which is the main CPU of product A. Further, an operational inspection needs to be conducted on the IC 22 and the switch components 14. The writing and the inspection are both performed using a test jig (not shown). The test jig includes pins corresponding to the write pads 12 and the inspection pads 13 of the interface circuit board 10. The writing and the inspection are both performed in the same step by accessing the interface circuit board 10 through each pin. In the example of Fig. 2, the writing of data to the IC 21 and the inspection of the IC 22 and the switch components 14 are performed in a single step.

When the functional circuit board 2 (product B) and the interface circuit board 10 are combined to form a second circuit board structure, data needs to be written to the IC 23, which is the main CPU of product B. Further, an operational inspection needs to be conducted on the IC 22 and the switch components 14. The writing and the inspection are both performed using the test jig. As long as the circuit board structure includes the common interface circuit board 10, there is no need to change the pin layout in order to access the interface circuit board 10. Thus, the same test jig can be shared. In this example, the writing of data to the IC 23 and the inspection of the IC 22 and the switch components 14 are performed in a single step.

The present invention has the advantages described below.
(1) The functional circuit board 1 or 2 is selected in accordance with the product function and combined with the interface circuit board 10 to form a single circuit board structure. The interface circuit board 10 includes test terminals (write pads 12 and inspection pads 13) that are commonly shared by the functional circuit boards 1 and 2. Thus, even when the interface circuit board 10 is combined with a different functional circuit board (functional circuit board 1 or 2), the interface circuit board 10 can be accessed through the same test jig to write data or conduct testing such as an operational inspection. In this manner, the same test jig can be commonly used for different functional circuit boards.
(2) The interface circuit board 10 includes the write pads 12, which are used to write data to the IC 21 and the IC 23, and the inspection pads 13, which are used to conduct and operational inspection on the IC 22. The write pads 12 and the inspection pads 13 function as the test terminals. Thus, the writing and the inspection can both be performed in the same step. This allows the manufacturing cost to be reduced.
(3) In addition to advantage (2), the interface circuit board 10 further include the inspection pads 15 that are used to conduct and operational inspection on the switch components 14. Thus, the writing of data to ICs, the inspection of ICs, and the inspection of the switch components 14 can be performed in the same step.
(4) The same circuit board can be used by changing the product function in accordance with the mounted IC. This increases variations of product functions and eliminates the need to newly design a circuit board. Thus, a quantitative merit is included in the circuit board manufacturing cost.
(5) The test pads (test terminals) are concentrated in the interface circuit board 10. This eliminates the need for the functional circuit board 1 or 2 to include test pads. Thus, restrictions are reduced in the wiring patterns (bypassing of ICs and elements) of the functional circuit boards 1 and 2. This allows the circuit board to be smaller and the product to be more compact.

It should be apparent to those skilled in the art that the present invention may be embodied in many other specific forms without departing from the spirit or scope of the invention. Particularly, it should be understood that the present invention may be embodied in the following forms.

The interface circuit board may include common test terminals shared by three or more functional circuit boards

A single circuit board structure may include two or more functional circuit boards.

The functional circuit board and the interface circuit board may be connected in any manner.

Any type of connector can be selected.

Any type of circuit board can be selected. For example, a flexible circuit board having superior flexibility may be selected.

The circuit board may be formed from any material. For example, the material may be a glass epoxy resin.

The circuit board structure may include test terminals other than those used for writing data or conducting inspections.

The product function is not limited to the electronic key function and the remote engine starting function.

The product is not limited to a portable device.

The present examples and embodiments are to be considered as illustrative and not restrictive, and the invention is not to be limited to the details given herein, but may be modified within the scope and equivalence of the appended claims.
A circuit board structure includes a test terminal. The circuit board structure includes and interface circuit board and a functional circuit board (1 or 2). The interface circuit board includes common test terminals (12 and 13) shared by different functional circuit boards (1 and 2). The functional circuit board (1 or 2) realizes a product function. The functional circuit board (1 or 2) is selected from a plurality of functional circuit boards (1 and 2) respectively realizing different product functions. Circuit components (5 and 21-23) required for each product function are mounted on the corresponding functional circuit board (1 or 2).

## Claims

1. A circuit board structure including a test terminal, the circuit board structure being **characterized by** comprising:
an interface circuit board (10) that includes common test terminals (12 and 13) shared by different functional circuit boards (1 and 2); and
a functional circuit board (1 or 2) realizing a product function, wherein the functional circuit board (1 or 2) is selected from a plurality of functional circuit boards (1 and 2) respectively realizing different product functions, and circuit components (5 and 21-23) required for each product function are mounted on the corresponding functional circuit board (1 or 2).

2. The circuit board structure according to claim 1, wherein the test terminals (12 and 13) of the interface circuit board (10) include
a write pad (12) used to write data to the circuit components (5 and 21-23), and
an inspection pad (13) used to conduct an operational inspection on the circuit components (5 and 21-23).

3. The circuit board structure according to claim 1 or 2, wherein
the plurality of functional circuit boards (1 and 2) include a common circuit board (3),
the common circuit board (3) includes
a common pattern formed on the common circuit board (3), wherein the common pattern includes mounting regions in which the circuit components (5 and 21-23) required for each product function are all mounted, and
a circuit component selected in accordance with the corresponding product function, wherein the selected circuit component is mounted in a corresponding one of the mounting regions.

4. The circuit board according to any one of claims 1-3, wherein the circuit components (5 and 21-23) include a main CPU that differs between functional circuit boards (1 and 2).

5. The circuit board structure according to any one of claims 1-4, wherein the circuit components (5 and 21-23) includes a common IC shared by at least two functional circuit boards (1 and 2).

6. The circuit board structure according to claim 1, wherein the functional circuit board (1 or 2) including
a common circuit board (3) that includes a common pattern, which includes mounting regions where circuit components (5 and 21-23) are mountable, formed on the common circuit board (3); and
certain ones of the circuit components (5 and 21-23) that realize the product function and are mounted on corresponding ones of the mounting regions of the common circuit board (3).

7. The circuit board structure according to claim 6, wherein
the common circuit board (3) of the functional circuit board (1 or 2) includes a first connector (5) electrically connected to the mounting regions,
the interface circuit board (10) includes a second connector (11) electrically connected to the test terminals (12 and 13), and
the first connector of the functional circuit board (1 or 2) is connected to the second connector of the interface circuit board (10).

8. The circuit board structure according to claim 7, wherein
the first connector of (5) the functional circuit board (1 or 2) includes common first terminals shared by the sets of the circuit components (5 and 21-23),
the second connector (11) of the interface circuit board (10) includes second terminals connected to the first terminals of the first connector and electrically connected to the test terminals (12 and 13).

9. The circuit board structure according to claim 8, wherein:
the interface circuit board (10) is placed on the functional circuit board (1 or 2);
the functional circuit board (1 or 2) includes an upper surface opposed to the interface circuit board (10), wherein the first connector (5) is mounted on the upper surface;
the interface circuit board (10) includes a lower surface and an upper surface opposite to the lower surface, wherein the lower surface of the interface circuit board (10) is opposed to the functional circuit board (1 or 2), the second connector (11) is mounted on the lower surface, and the test terminals (12 and 13) are mounted on the upper surface of the interface circuit board (10).
